# EUROPEAN PATENT APPLICATION

(11) **EP 4 794 501 A1**
(43) Date of publication of application: **19.08.2026**
(21) Application number: 26151322.0
(22) Date of filing: 12.01.2026
(51) Int. Cl.: H10K 59/80

(54) **DISPLAY PANEL AND ELECTRONIC APPARATUS INCLUDING THE SAME**

(30) Priority: 18.02.2025 KR 20250020962
(71) Applicant: Samsung Display Co., Ltd., Yongin-si, Gyeonggi-do 17113 (KR)
(72) Inventor: Jang, Yun, 17113 Yongin-si, Gyeonggi-do (KR); Lazo Martinez, Israel Esteban, 17113 Yongin-si, Gyeonggi-do (KR); Suh, Duckjong, 17113 Yongin-si, Gyeonggi-do (KR)
(74) Representative: Gulde & Partner

(57) **Abstract**

A display panel (10) in which efficiency of light generated from an emission layer (222bR, 222bG, 222bB) and emitted to the outside is high (e.g., increased or enhanced) and an electronic apparatus including the display panel (10) are disclosed. The display panel (10) may include a substrate (200), a pixel electrode (221R, 221G, 221B) disposed or arranged on the substrate (100) and including a chiral metasurface reflector (221Ba, 221Ga, 221Ra), a reflective plate (224) between the substrate (100) and the pixel electrode (221R, 221G, 221B), a thickness adjustment layer (213) between the reflective plate (224) and the pixel electrode (221R, 221G, 221B), and an emission layer on the pixel electrode (221R, 221G, 221B).

## Description

### BACKGROUND

### 1. Field

One or more embodiments of the present disclosure relate to a display panel and an electronic apparatus including the display panel. For example, one or more embodiments of the present disclosure relate to a display panel in which efficiency of light generated from an emission layer and emitted to the outside is high (e.g., increased or enhanced) and an electronic apparatus including the display panel.

### 2. Description of the Related Art

Display panels are utilized in one or more suitable electronic apparatuses. In order to increase or enhance the power usage efficiency of the electronic apparatuses and to increase or enhance the user visibility of displayed images, it is necessary or desirable to increase or enhance the efficiency of light generated from an emission layer and emitted to the outside. For example, to improve or enhance power efficiency and enhance the visibility of displayed images, it is desirable to increase or enhance the efficiency with which light generated from an emission layer is emitted to the outside.

### SUMMARY

One or more aspects of embodiments of the present disclosure are directed toward a display panel and an electronic apparatus including the display panel that have high (e.g., increased or enhanced) light extraction efficiency.

One or more aspects of embodiments of the present disclosure are directed toward a display panel in which efficiency of light generated from an emission layer and emitted to the outside is high (e.g., increased or enhanced) and an electronic apparatus including the display panel. However, these embodiments are examples, and the present disclosure is not limited to the embodiments as described.

Additional aspects of embodiments will be set forth in part in the description which follows and, in part, will be apparent from the description, or may be learned by practice of the presented embodiments of the disclosure.

According to one or more embodiments, a display panel includes a substrate, a pixel electrode arranged on the substrate and including a chiral metasurface reflector, a reflective plate between the substrate and the pixel electrode, the thickness adjustment layer between the reflective plate and the pixel electrode, and an emission layer arranged over the pixel electrode.

The chiral metasurface reflector may be to transmit any one selected from left-circularly polarized light and right-circularly polarized light and may be to reflect the other (e.g., configured or arranged to transmit either left-circularly polarized light or right-circularly polarized light and to reflect the opposite circularly polarized light (e.g., the circularly polarized light of opposite handedness)).

The pixel electrode may further include a first oxide conductor (e.g., electrical conductor) between the chiral metasurface reflector and the emission layer.

The pixel electrode may further include a second oxide conductor (e.g., electrical conductor) between the thickness adjustment layer and the chiral metasurface reflector.

The display panel may further include a common electrode arranged over the emission layer.

The display panel may further include a λ/4 phase retardation plate arranged on the common electrode, and a linear polarization plate arranged on the λ/4 phase retardation plate.

If (e.g., when) a wavelength of light emitted from the emission layer is λ and n is a natural number, a distance d1 between the chiral metasurface reflector and the emission layer may be such that (e.g., may be defined as) d1=nλ/2.

The distance d1 between the chiral metasurface reflector and the emission layer may be such that (e.g., may be defined as) d1=λ/2.

If (e.g., when) a wavelength of light emitted from the emission layer is λ and k is 0 or a natural number, a distance d2 between the reflective plate and the emission layer may be such that (e.g., may be defined as) d2=(2k+1)λ/4.

The distance d2 between the reflective plate and the emission layer may be such that (e.g., may be defined as) d2=λ/4.

The chiral metasurface reflector may include nano antennas, and each of the nano antennas may include a body portion and prong portions radially extending from the body portion.

The chiral metasurface reflector may include nano antennas each having a rectangular shape (e.g., a substantially rectangular shape) in plan view.

According to one or more embodiments, an electronic apparatus includes a processor, and a display panel controlled by the processor, wherein the display panel includes a substrate, a pixel electrode arranged on the substrate and including a chiral metasurface reflector, a reflective plate between the substrate and the pixel electrode, the thickness adjustment layer between the reflective plate and the pixel electrode, and an emission layer arranged over the pixel electrode.

The chiral metasurface reflector may be to transmit any one selected from left-circularly polarized light and right-circularly polarized light and may be to reflect the other (e.g., configured or arranged to transmit either left-circularly polarized light or right-circularly polarized light and to reflect the opposite circularly polarized light (e.g., the circularly polarized light of opposite handedness)).

The pixel electrode may further include a first oxide conductor (e.g., electrical conductor) between the chiral metasurface reflector and the emission layer.

The pixel electrode may further include a second oxide conductor (e.g., electrical conductor) between the thickness adjustment layer and the chiral metasurface reflector.

The electronic apparatus may further include a common electrode arranged over the emission layer.

The electronic apparatus may further include a A/4 phase retardation plate arranged on the common electrode and a linear polarization plate arranged on the λ/4 phase retardation plate.

If (e.g., when) a wavelength of light emitted from the emission layer is λ and n is a natural number, a distance d1 between the chiral metasurface reflector and the emission layer may be such that (e.g., may be defined as) d1=nλ/2.

If (e.g., when) a wavelength of light emitted from the emission layer is λ and k is 0 or a natural number, a distance d2 between the reflective plate and the emission layer may be such that (e.g., may be defined as) d2=(2k+1)λ/4.

For example, the configurations or arrangements and features described herein are directed toward improving or enhancing the light extraction efficiency of a display panel by leveraging a chiral metasurface reflector and enhanced optical layer arrangements. By selectively transmitting and reflecting circularly polarized light, and by precisely controlling the distances between optical layers based on the emission wavelength, the described embodiments aim to reduce optical losses and enhance display brightness and energy efficiency. These improvements are advantageous or beneficial in electronic apparatuses where power consumption and display performance are important. However, aspects and features of embodiments of the present disclosure are not restricted to the one set forth herein. The above and other aspects and features of certain embodiments of the present disclosure will become more apparent to one of ordinary skill in the art to which the present disclosure pertains by referencing the accompanying drawings, the appended claims and equivalents thereof, and the detailed description of the present disclosure given.

### BRIEF DESCRIPTION OF THE DRAWINGS

The above and other aspects and features of certain embodiments of the present disclosure will be more apparent from the following description taken in conjunction with the accompanying drawings, in which:
FIG. 1 is a schematic block diagram of an electronic apparatus according to one or more embodiments;
FIG. 2 is a schematic diagram illustrating electronic apparatuses according to one or more embodiments;
FIG. 3 is a schematic diagram illustrating a case in which the electronic apparatuses according to one or more embodiments are wearable electronic apparatuses;
FIG. 4 is a schematic diagram illustrating a case in which an electronic apparatus according to one or more embodiments is an electronic apparatus for a vehicle;
FIG. 5 is a schematic plan view of a display module including a display panel according to one or more embodiments;
FIG. 6 is a schematic side view of the display module of FIG. 5;
FIG. 7 is a schematic cross-sectional view of the display panel of FIG. 5 taken along the line A-A';
FIG. 8 is an enlarged schematic cross-sectional view of a region B of FIG. 7;
FIG. 9 is a schematic cross-sectional view of parts of a display panel according to one or more embodiments;
FIG. 10 is a schematic perspective view of a chiral metasurface reflector of a display panel according to one or more embodiments and an electronic apparatus including the display panel;
FIG. 11 is a schematic plan view of the chiral metasurface reflector of FIG. 10;
FIG. 12 is a schematic plan view of a chiral metasurface reflector of a display panel according to one or more embodiments and an electronic apparatus including the display panel; and
FIG. 13 is an enlarged plan view of a part of the chiral metasurface reflector of FIG. 12.

### DETAILED DESCRIPTION

Reference will be made in more detail to one or more embodiments, examples of which are illustrated in the accompanying drawings, wherein like reference numerals refer to like elements throughout the attached drawings and the written description, and duplicative descriptions thereof may not be provided in the specification. In this regard, the subject matter of the present disclosure may be embodied in different forms and should not be construed as being limited to one or more embodiments set forth herein. Rather, these embodiments are provided as examples, by referring to the drawings, to explain the aspects and features of the present disclosure to those skilled in the art.

The utilization of "may" if (e.g., when) describing embodiments of the present disclosure refers to "one or more embodiments of the present disclosure."

As used herein, the singular forms "a," "an," and "the" are intended to include the plural forms as well, unless the context clearly indicates otherwise. The singular expression includes the plural expression unless the context clearly dictates otherwise.

As used herein, the term "and/or" includes any and all combinations of one or more of the associated listed items.

Throughout the disclosure, the expression "at least one of a, b, or c" indicates only a, only b, only c, both (e.g., simultaneously) a and b, both (e.g., simultaneously) a and c, both (e.g., simultaneously) b and c, all of a, b, and c, or variations thereof.

One or more suitable modifications may be applied to one or more embodiments of the present disclosure, and particular embodiments will be illustrated in the drawings and described in the detailed description section. The aspects and features of embodiments of the present disclosure, and a method to achieve them, will be clearer referring to the detailed descriptions with the drawings. However, embodiments of the present disclosure may be implemented in one or more suitable forms, not by being limited to the embodiments presented herein.

Hereinafter, the subject matter of the present disclosure will be described in more detail with reference to the accompanying drawings, and in the description with reference to the drawings, substantially the same or corresponding constituents may be indicated by the same reference numerals, and redundant descriptions thereof may not be provided.

In the present disclosure, it will be understood that if (e.g., when) a component, such as a layer, a film, a region, or a plate, is referred to as being "on" or "above" another component, the component may be directly on or directly above the other component or intervening components may be present therebetween. In contrast, if (e.g., when) a component is referred to as being "directly on" or "directly above" another component, there are no intervening components present therebetween.

Furthermore, for convenience of explanation, in the drawings, sizes of components may be exaggerated or reduced. For example, because sizes and thicknesses of elements in the drawings may be arbitrarily illustrated for convenience of explanation, embodiments of present disclosure are not limited thereto.

In the present disclosure, the x-axis, the y-axis, and the z-axis are not limited to three axes of the rectangular coordinate system and may be interpreted in a broader sense. For example, the x-axis, the y-axis, and the z-axis may be perpendicular (e.g., substantially perpendicular) to one another or may represent different directions that are not perpendicular to one another.

In the present disclosure, it will be understood that although the terms "first," "second," and/or the like may be used herein to describe one or more suitable components, these components should not be limited by these terms. These terms may only be used to distinguish one element from another.

In the present disclosure, it will be further understood that the terms "has," "having," "includes," and/or "including" used herein specify the presence of stated features or elements, but do not preclude the presence or addition of one or more other features or elements. For example, it should be understood that the term "comprise(s)/comprising," "include(s)/including," or "have/has/having" specifies the presence of stated features, integers, steps, operations, elements, and/or components, but do not preclude the presence or addition of one or more other features, integers, steps, operations, elements, components, and/or groups thereof. Also, the terms "comprise(s)/comprising," "include(s)/including," "have/has/having," or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

As utilized herein, the terms "substantially," "about," or similar terms are used as terms of approximation and not as terms of degree and are intended to account for the inherent deviations in measured or calculated values that would be recognized by those of ordinary skill in the art. "About" as used herein is inclusive of the stated value and refers to as being within an acceptable range of deviation for the particular value as determined by one of ordinary skill in the art, considering the measurement in question and the error associated with measurement of the particular quantity (e.g., the limitations of the measurement system). For example, "about" may refer to as being within one or more standard deviations or within ±30%, ±20%, ±10%, or ±5% of the stated value. Also, it should be understood that, even if (e.g., when) the terms "about," "approximately," or "substantially" are not expressly recited in a given element (e.g., a claim element), the scope of such element is intended to include variations that are insubstantial or within the understanding of one of ordinary skill in the art. For example, numerical values and ranges provided herein are intended to include tolerances and measurement uncertainties that would be recognized by those skilled in the art, and the elements (e.g., claim elements) should be construed accordingly to encompass such equivalents.

In the present disclosure, the expression, such as "at least one of A and B" may include A, B, or A and B.

It will be understood that if (e.g., when) a layer, a region, or a component is referred to as being "connected to" another layer, region, or component, it may be directly connected to the other layer, region, or component or indirectly connected to the other layer, region, or component via intervening layers, regions, or components. For example, in the disclosure, if (e.g., when) a layer, a region, or a component is referred to as being electrically connected to another layer, region, or component, it may be directly electrically connected to the other layer, region, or component or indirectly electrically connected to the other layer, region, or component via intervening layers, regions, or components.

In the context of the present disclosure and unless otherwise defined, plan view is an orthographic projection of a three-dimensional object from the position of a horizontal plane that intersects the object. For example, it is a top-down view, showing the layout and spatial relationships of one or more elements within the object or structure. A plan view based on a z-axis (thickness) direction refers to a top-down view of the object, as if (e.g., when) looking directly down onto the surface from above. In this context, the z-axis direction is perpendicular or normal to the horizontal plane defined by x-axis and y-axis directions.

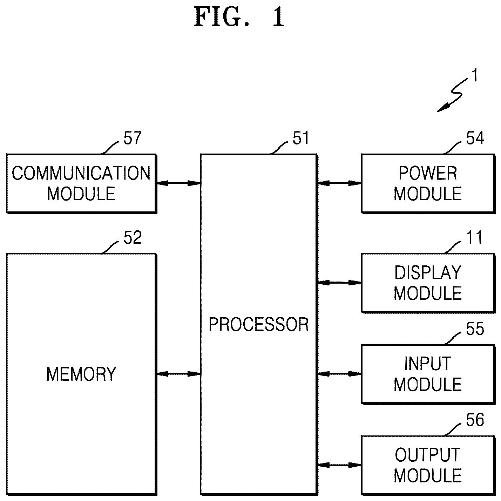

FIG. 1 is a schematic block diagram of an electronic apparatus 1 according to one or more embodiments. The electronic apparatus 1 according to the present disclosure may be a display device or may further include a module having other additional functions in addition to a display module 11.

As illustrated in FIG. 1, the electronic apparatus 1 according to the present disclosure may include the display module 11, a processor 51, a memory 52, a power module 54, an input module 55, an output module 56, and a communication module 57.

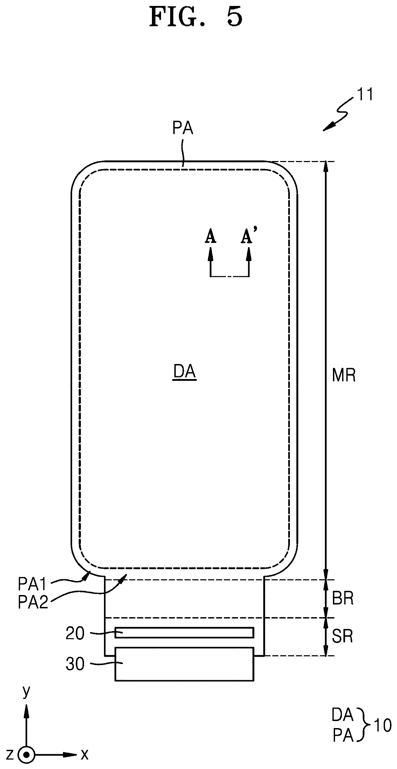

The display module 11 may include a display panel 10 (see FIG. 5) as described in one or more embodiments. For example, the display module 11 may include the display panel 10 and a data driver 20 (see FIG. 5) mounted on the display panel 10. The display panel 10 is described herein in more detail.

The processor 51 may be to control most (e.g., substantially all) components of the electronic apparatus 1. For example, the processor 51 may be to output digital video data to the display module 11 so that (e.g., such that) the display module 11 displays an image and to receive input data output from the input module 55 so that (e.g., such that) a function according to the data is performed by the electronic apparatus 1. The processor 51 may include at least one selected from among a central processing unit (CPU), an application processor (AP), a graphics processing unit (GPU), a communication processor (CP), an image signal processor (ISP), and a controller.

If (e.g., when) necessary or desired, the processor 51 may be provided split into two or more units from a functional or structural perspective. For example, the processor 51 may include a main processor in the form of a first driving chip including a CPU, and an auxiliary processor in the form of a second driving chip which is a part of the display module 11. The auxiliary processor in the form of the second driving chip may include a controller which is to receive an image signal from the main processor and process the image signal to meet the interface specifications of the display panel 10 in the display module 11.

The memory 52 may include at least one selected from non-volatile memory and volatile memory. The memory 52 may be to store data information necessary or desired for an operation of the processor 51 or the display module 11. If (e.g., when) the processor 51 executes an application stored in the memory 52, image data signals and/or input control signals may be transmitted to the display module 11, and the display module 11 may process the received signals and output image information.

The power module 54 may include a power supply module, such as a power adapter and/or a battery device, and a power conversion module which is to convert power supplied by the power supply module to generate power necessary or desired for an operation of the electronic apparatus 1. Power conversion by the power conversion module may include direct current (DC)-DC conversion, alternating current (AC)-DC conversion, and DC-AC conversion. However, embodiments of the present disclosure are not limited thereto.

The input module 55 may be to provide input information to the processor 51 and/or the display module 11. The input module 55 may include one or more suitable sensor modules as well as physical buttons, a keyboard, and a microphone. Examples of the sensor modules may include touch sensors, pressure sensors, distance sensors, position sensors, digitizers, motion recognition sensors, camera sensors, photodetectors, photoelectric conversion sensors, and/or temperature sensors. Furthermore, the sensor modules may include biosensors, such as blood pressure sensors, blood sugar sensors, electrocardiogram sensors, and/or heart rate sensors.

The output module 56 may be to receive information other than the image transmitted from the processor 51 and provide the received information to the user. The output module 56 may include, for example, sound modules, haptic modules, and/or light-emitting modules. Furthermore, the output module 56 may include other functional modules unique to the electronic apparatus 1, such as a cooling module in a refrigerator.

For reference, the display module 11 may also have an output function. For example, the display panel 10 in the display module 11 may be to display (e.g., output) the information processed by the electronic apparatus 1. For example, the display panel 10 may be to display a screen image of an application driven in the electronic apparatus 1, a user interface (UI) according to information of the screen image, or a graphical user interface (GUI) information. The display panel 10 may include a display layer to display an image and a touch screen layer to detect a touch input by a user. Accordingly, the display panel 10 may be to function as a part of the input module 55 that is to provide an input interface between the electronic apparatus 1 and the user and concurrently (e.g., simultaneously) as a part of the output module 56 that is to provide an output interface between the electronic apparatus 1 and the user.

The communication module 57 is a module to transmit and receive information between the electronic apparatus 1 and an external device and may include a reception unit and a transmission unit. The communication module 57 may include one or more suitable wireless communication modules, such as a mobile communication module, a broadcast receiving module, a wireless Internet module, a short-range communication module, a wireless fidelity (Wi-Fi) module, and/or a Bluetooth module, or one or more suitable wired communication modules.

The electronic apparatus 1 as illustrated in FIG. 1 is an example, and for example, in the case of a display device without a communication function, the electronic apparatus 1 may not include (e.g., may exclude) the communication module 57. Furthermore, for example, if (e.g., when) the electronic apparatus 1 includes a display device, at least one selected from among the components of the electronic apparatus 1 as described in one or more embodiments may be in the display device. Furthermore, one or more of individual modules functionally included within a single module may be included within the display device, and other individual modules may be separately included in the electronic apparatus 1. For example, the display device may include the display module 11, and the processor 51, the memory 52, and the power module 54 may be the components of the electronic apparatus 1, not the display device. In one or more embodiments, one or more suitable modifications may be feasible, for example, the display device includes the display module 11 and the power module 54, and the power module 54 may be to supply power to the components, such as the processor 51 and the memory 52 of the electronic apparatus 1.

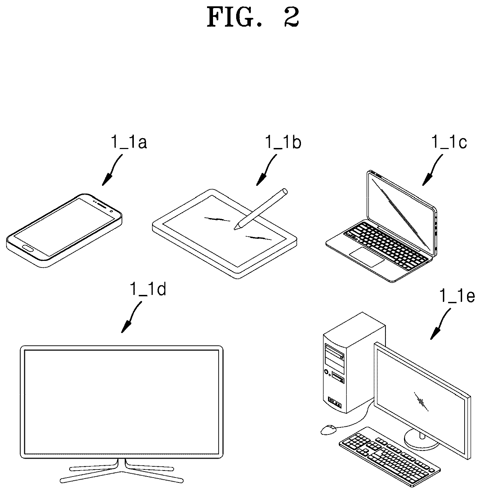

FIG. 2 is a schematic diagram illustrating the electronic apparatus 1 according to one or more embodiments. In FIG. 2, examples of the electronic apparatus 1 may include a smartphone 1_1a, a tablet personal computer (PC) 1_1b, a laptop 1_1c, a television (TV) 1_1d, and a desktop monitor 1_1e.

The smartphone 1_1a may include not only the processor 51, the memory 52, the power module 54, and the display module 11, but also the input module 55, such as a touch sensor, and the communication module 57. The smartphone 1_1a may be to display information through the display module 11 by processing information received through the communication module 57 or other input modules.

The tablet PC 1_1b, the laptop 1_1c, the TV 1_1d, and/or the desktop monitor 1_1e, may also include the display module 11 and the input module 55, similarly to the smartphone 1_1a, and, in one or more cases, may include the communication module 57.

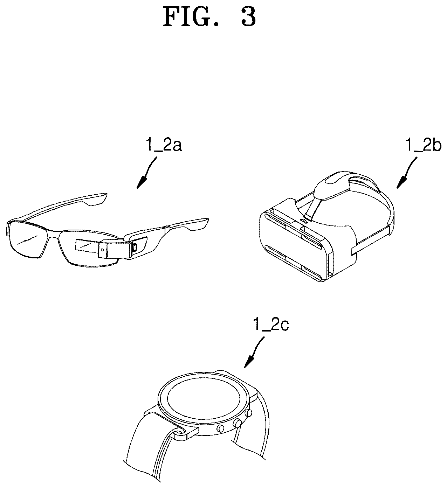

FIG. 3 is a schematic diagram illustrating a case in which the electronic apparatus 1 according to one or more embodiments is a wearable electronic apparatus. In FIG. 3, examples of the electronic apparatus 1 may include a pair of smart glasses 1_2a, a head-mounted display 1_2b, and a smart watch 1_2c.

The smart glasses 1_2a and the head-mounted display 1_2b may include the display module 11 to display an image and a reflector that reflects a display surface displaying the image and provides the reflected display surface to the eyes of a user. The user may experience virtual reality or augmented reality through the electronic apparatus 1.

The smart watch 1_2c may include a biometric sensor as the input module 55 and provide biometric information recognized by the biometric sensor to the user through the display module 11.

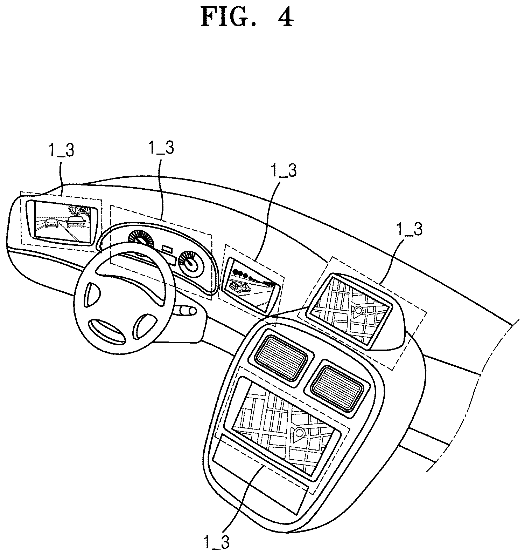

FIG. 4 is a schematic diagram illustrating a case in which the electronic apparatus 1 according to one or more embodiments is an electronic apparatus 1_3 for a vehicle. As illustrated in FIG. 4, the electronic apparatus 1_3 for a vehicle may be applied to a dashboard, center fascia, and/or the like of a vehicle, or to a center information display (CID) arranged on the dashboard of a vehicle or a room mirror display that replaces a side mirror.

The electronic apparatus 1 according to the present disclosure is not limited to the descriptions presented herein. For example, the electronic apparatus 1 according to one or more embodiments may include not only devices which mainly or predominantly display screens, such as billboards, electronic boards, and game consoles, but also one or more suitable home appliances which display information through the display module 11, such as refrigerators, washing machines, dryers, air conditioners, and/or robot vacuum cleaners. Furthermore, if (e.g., when) the display module 11 has a function to transmit light, the electronic apparatus 1 may be, for example, smart windows or transparent (e.g., substantially transparent) display devices which display a background and a displayed image together. However, the electronic apparatus 1 according to the present disclosure is not limited thereto, and the electronic apparatus 1 including the display panel 10 as described in one or more embodiments may be said to fall within the scope of the disclosure.

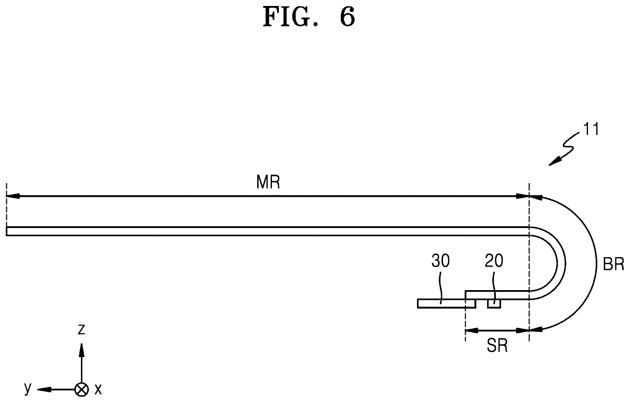

FIG. 5 is a schematic plan view of the display module 11 including the display panel 10 according to one or more embodiments. FIG. 6 is a schematic side view of the display module 11 of FIG. 5. The display module 11 in the electronic apparatus 1 as described in one or more embodiments may include the display panel 10 as illustrated in FIGS. 5 and 6. This is substantially the same as the embodiments described in one or more embodiments and modified examples thereof.

The display panel 10 may have an approximately (substantially) rectangular shape in plan view. For example, the display panel 10 may have, as illustrated in FIG. 5, an approximately rectangular shape having a short side in an x-axis direction and a long side in a y-axis direction, on an x-y plane. In this state, a corner where the short side in the x-axis direction meets the long side in the y-axis direction may form a right angle corner or a round (e.g., substantially round) shape to have a certain (e.g., set or predetermined) curvature. In plan view, the display panel 10 may have other polygonal shapes (e.g., substantially polygonal shapes), not a rectangular shape, or an oval shape (e.g., a substantially oval shape) or an amorphous shape.

The display panel 10 may include a display area DA and a peripheral area PA outside (e.g., around or surrounding) the display area DA. The display area DA may be a portion to display an image, and a plurality of pixels may be in the display area DA. The display area DA may have one or more suitable shapes, such as a circular shape (e.g., a substantially circular shape), an oval shape (e.g., a substantially oval shape), a polygonal shape (e.g., a substantially polygonal shape), or a specific (e.g., set or predetermined) figure shape. FIG. 5 illustrates that the display area DA has an approximately rectangular shape with round corners.

The peripheral area PA may be outside (e.g., around or surrounding) the display area DA. The peripheral area PA may include a first peripheral area PA1 around (e.g., surrounding) at least part of the display area DA and a second peripheral area PA2 in a lower end of the display area DA and extending in a first direction (x-axis direction). For example, the second peripheral area PA2 may be in a lower end of the display area DA in a second direction (y-axis direction). The width of the second peripheral area PA2 in the first direction (x-axis direction) may be less than the width of the display area DA in the first direction (x-axis direction). Such a structure may facilitate bending of at least a part of the second peripheral area PA2.

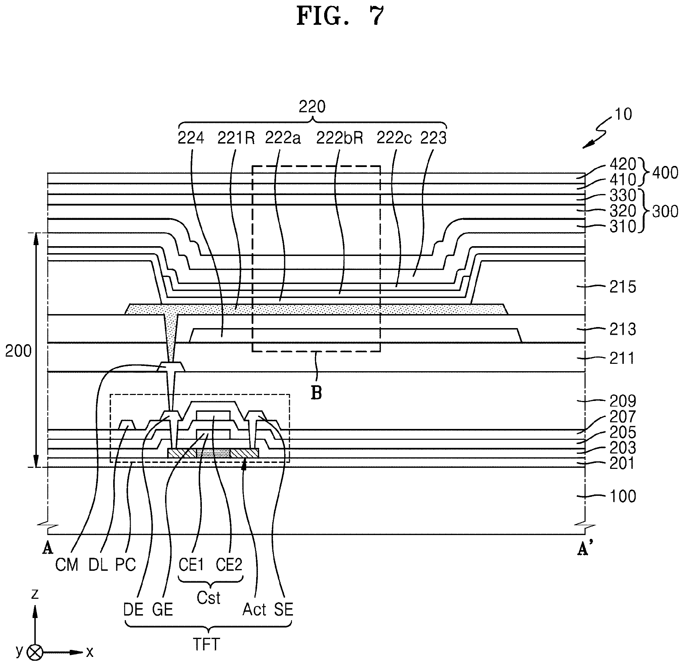

A planar shape of the display panel 10 as illustrated in FIG. 5 may be substantially the same as the shape of a substrate 100 (see FIG. 7) in the display panel 10. If (e.g., when) the display panel 10 includes the display area DA and the peripheral area PA outside (e.g., around or surrounding) the display area DA, it may be stated that the substrate 100 includes the display area DA and the peripheral area PA outside (e.g., around or surrounding) the display area DA. In the following description, for convenience of explanation, the substrate 100 includes the display area DA and the peripheral area PA.

The display panel 10 may include a main region MR, a bending region BR outside (e.g., around or surrounding) the main region MR, and a sub-region SR apart from the main region MR with the bending region BR between the main region MR and the sub-region SR. The main region MR may be arranged on one side of the bending region BR, and the sub-region SR may be arranged on the other side of the bending region BR. The display panel 10 may be bent in the bending region BR, as illustrated in FIG. 6, and if (e.g., when) viewed from a third direction (z-axis direction), at least part of the sub-region SR may overlap the main region MR.

FIG. 6 illustrates that the display panel 10 is bent, but embodiments of the present disclosure are not limited thereto. For example, the display panel 10 may be a foldable display panel, and in this case, the display panel 10 may be folded within the display area DA with respect to a folding axis crossing the display area DA. If (e.g., when) necessary or desired, the display panel 10 may not be bent. The sub-region SR may be a non-display area.

As such, the display panel 10 may be a rigid display panel that has stiffness and does not bend easily, or a flexible display panel that has flexibility and may be easily bent, folded, or rolled. For example, the display panel 10 may be a foldable display panel that may be folded and unfolded, a curved display panel with a curved display surface, a bended display panel in which an area other than the display surface is curved, a rollable display panel that may be rolled or unrolled, or a stretchable display panel.

The display module 11 including the display panel 10 may include the data driver 20 mounted in the sub-region SR of the display panel 10. The data driver 20 may be arranged in the display panel 10 in the form of an integrated circuit (IC). For example, the data driver 20 may be a data driving IC to generate a data signal. The data driver 20 may be an auxiliary processor in the form of a second driving chip as described in one or more embodiments and may be a part of the processor 51.

A display circuit board 30 may be attached to an end portion of the sub-region SR of the display panel 10. For example, if (e.g., when) necessary or desired, the display module 11 may include the display circuit board 30. The display circuit board 30 may be electrically connected to the data driver 20 through a pad of the sub-region SR of the display panel 10.

FIG. 7 is a schematic cross-sectional view of the display panel 10 of FIG. 5 taken along the line A-A'. As illustrated in FIG. 7, the display panel 10 may include the substrate 100. One or more suitable components constituting the display panel 10 may be arranged on the substrate 100. For example, a display layer 200, a thin-film encapsulation layer 300, and/or an anti-reflection layer 400 may be arranged on the substrate 100.

The substrate 100 may include glass, ceramic, metal, and/or a polymer resin. The substrate 100 may include, for example, a polymer resin, such as polyethersulfone, polyacrylate, polyetherimide, polyethylene naphthalate, polyethylene terephthalate, polyphenylene sulfide, polyarylate, polyimide, polycarbonate, and/or cellulose acetate propionate. The substrate 100 may have a multilayer structure including two layers including the polymer resin and an inorganic material layer provided or arranged between the two layers. In one or more embodiments, the substrate 100 may have a structure in which the layer including a polymer resin and the inorganic material layer are alternately stacked. The inorganic material layer may include, for example, silicon oxide (e.g., SiO_{X}, wherein 0 < x ≤ 2; e.g., SiO₂), silicon nitride (e.g., SiNₓ, wherein 0 < x ≤ 2; e.g., Si₃N₄), and/or silicon oxynitride (e.g., SiOₓN_{y}, wherein 0 < x ≤ 2 and 0 < y ≤ 2; e.g., SiON or Si₂N₂O) and may have a single layer structure or a multilayer structure. The inorganic material layer may act or serve as a barrier layer to prevent infiltration of an external foreign material (or to reduce a degree or occurrence of infiltration of an external foreign material).

The display layer 200 may have a plurality of pixels. The display layer 200 may include a display element 220 at each pixel, a pixel circuit at each pixel, and insulating (e.g., electrically insulating) layers. Each pixel circuit may include a thin film transistor TFT and a storage capacitor Cst. The display element 220 may include, for example, an organic light-emitting diode (OLED).

The thin-film encapsulation layer 300 may cover the display layer 200. The thin-film encapsulation layer 300 may include at least one inorganic encapsulation layer and at least one organic encapsulation layer. The thin-film encapsulation layer 300 may prevent infiltration of impurities (or reduce a degree or occurrence of infiltration of impurities), such as external moisture into the display element 220.

The anti-reflection layer 400 may be to prevent reflection of external light (or reduce a degree or occurrence of reflection of external light) inside the display panel 10 and/or on the display panel 10. The anti-reflection layer 400 may include a linear polarization plate 420 and a λ/4 phase retardation plate 410.

In one or more embodiments, the display layer 200, the thin-film encapsulation layer 300, and the anti-reflection layer 400 are described in more detail.

A buffer layer 201', which may prevent infiltration of impurities (or to reduce a degree or occurrence of infiltration of impurities) into a semiconductor layer Act of the thin film transistor TFT, may be arranged on the substrate 100. The buffer layer 201 may include an inorganic insulating (e.g., electrically insulating) material, such as silicon oxide (e.g., SiO_{X}, wherein 0 < x ≤ 2; e.g., SiO₂), silicon oxynitride (e.g., SiOₓN_{y}, wherein 0 < x ≤ 2 and 0 < y ≤ 2; e.g., SiON or Si₂N₂O), and/or silicon nitride (e.g., SiNₓ, wherein 0 < x ≤ 2; e.g., Si₃N₄) and may have a single layer structure or a multilayer structure.

A pixel circuit PC may be arranged on the buffer layer 201. The pixel circuit PC may include the thin film transistor TFT and the storage capacitor Cst. The thin film transistor TFT may include the semiconductor layer Act, a gate electrode GE, a source electrode SE, and/or a drain electrode DE. The thin film transistor TFT as illustrated in FIG. 7 may be a driving transistor. In one or more embodiments, If (e.g., when) an emission control transistor is provided or arranged between the driving transistor and the organic light-emitting diode OLED, the thin film transistor TFT, as a driving transistor, may not be connected to a first pixel electrode 221R of the organic light-emitting diode OLED through a contact metal layer CM, but may be electrically connected to the emission control transistor, and the emission control transistor may be electrically connected to the first pixel electrode 221R of the organic light-emitting diode OLED. If (e.g., when) necessary or desired, the thin film transistor TFT as illustrated in FIG. 7 may be regarded as an emission control transistor. In the following description, for convenience of explanation, a structure in which the thin film transistor TFT of FIG. 7 is connected to the first pixel electrode 221R of the organic light-emitting diode OLED through the contact metal layer CM is described in more detail.

A data line DL of the pixel circuit PC may be electrically connected to a switching transistor in the pixel circuit PC.

The semiconductor layer Act may include polysilicon. In one or more embodiments, the semiconductor layer Act may include amorphous (e.g., non-crystalline) silicon, an oxide semiconductor, and/or an organic semiconductor. The gate electrode GE may include a low resistance (e.g., electrical resistance) metal material. For example, the gate electrode GE may include a conductive (e.g., electrically conductive) material including molybdenum (Mo), aluminum (Al), copper (Cu), and/or titanium (Ti) and may have a multilayer structure or a single layer structure. For example, the gate electrode GE may have a three-layer structure of a Mo layer, an Al layer, and a Mo layer (Mo/Al/Mo).

A gate insulating layer 203 between the semiconductor layer Act and the gate electrode GE may include an inorganic insulating (e.g., electrically insulating) material, such as silicon oxide (e.g., SiO_{X}, wherein 0 < x ≤ 2; e.g., SiO₂), silicon nitride (e.g., SiNₓ, wherein 0 < x ≤ 2; e.g., Si₃N₄), silicon oxynitride (e.g., SiOₓN_{y}, wherein 0 < x ≤ 2 and 0 < y ≤ 2; e.g., SiON or Si₂N₂O), aluminum oxide (e.g., AlOₓ, wherein 0 < x ≤ 2; e.g., Al₂O₃), titanium oxide (e.g., TiOₓ, wherein 0 < x ≤ 2; e.g., TiO₂), tantalum oxide (e.g., TaOₓ, wherein 0 < x ≤ 3; e.g., Ta₂O₅), and/or hafnium oxide (e.g., HfO₂). The gate insulating layer 203 may have a single layer structure or a multilayer structure.

The source electrode SE and the drain electrode DE may be arranged on (e.g. substantially) the same layer as the data line DL and may include (e.g. substantially) the same material as the data line DL. The source electrode SE, the drain electrode DE, and the data line DL may each include a material with good or suitable conductivity (e.g., electrical conductivity). The source electrode SE and the drain electrode DE may each include a conductive (e.g., electrically conductive) material including Mo, Al, Cu, and/or Ti, and may have a multilayer structure or a single layer structure. For example, the source electrode SE, the drain electrode DE, and the data line DL may have a multilayer structure of a Ti layer, an Al layer, and a Ti layer (Ti/Al/Ti).

FIG. 7 illustrates that the thin film transistor TFT includes both (e.g., simultaneously) of the source electrode SE and the drain electrode DE, but embodiments of the present disclosure are not limited thereto. For example, a drain region of the semiconductor layer Act of the thin film transistor TFT may be integrated with a source region of a semiconductor layer of another thin film transistor. In this case, the thin film transistor TFT may not have the drain electrode DE and the other thin film transistor may not have a source electrode. In this case, in a circuit diagram, the drain region of the thin film transistor TFT may be connected to the source region of the other thin film transistor.

For example, if (e.g., when) the drain region of the driving transistor is connected to the source region of the emission control transistor, the driving transistor may not have a drain electrode and the emission control transistor may not have a source electrode, and a drain region of a semiconductor layer of the driving transistor may be integrated with a source region of the emission control transistor. Similarly, if (e.g., when) the source region of the driving transistor is connected to the drain region of an operation control transistor, the driving transistor may not have a source electrode and the operation control transistor may not have a drain electrode, and a source region of the semiconductor layer of the driving transistor may be integrated with a drain region of the operation control transistor. Accordingly, the driving transistor may not have both (e.g., simultaneously) of the source electrode and the drain electrode, as a result.

The storage capacitor Cst may include a lower electrode CE1 and an upper electrode CE2 overlapping each other with a first interlayer insulating (e.g., electrically insulating) layer 205 therebetween. The storage capacitor Cst may overlap the thin film transistor TFT. In FIG. 7, the gate electrode GE of the thin film transistor TFT is illustrated as the lower electrode CE1 of the storage capacitor Cst. However, embodiments of the present disclosure are not limited thereto, and the storage capacitor Cst may not overlap the thin film transistor TFT. The storage capacitor Cst may be covered by a second interlayer insulating layer 207. The upper electrode CE2 of the storage capacitor Cst may include a conductive (e.g., electrically conductive) material including Mo, Al, Cu, and/or Ti and may have a multilayer structure or a single layer structure.

The first interlayer insulating layer 205 and the second interlayer insulating layer 207 may each include an inorganic insulating (e.g., electrically insulating) material, such as silicon oxide (e.g., SiO_{X}, wherein 0 < x ≤ 2; e.g., SiO₂), silicon nitride (e.g., SiNₓ, wherein 0 < x ≤ 2; e.g., Si₃N₄), silicon oxynitride (e.g., SiOₓN_{y}, wherein 0 < x ≤ 2 and 0 < y ≤ 2; e.g., SiON or Si₂N₂O), aluminum oxide (e.g., AlOₓ, wherein 0 < x ≤ 2; e.g., Al₂O₃), titanium oxide (e.g., TiOₓ, wherein 0 < x ≤ 2; e.g., TiO₂), tantalum oxide (e.g., TaOₓ, wherein 0 < x ≤ 3; e.g., Ta₂O₅), and/or hafnium oxide (e.g., HfO₂). The first interlayer insulating layer 205 and the second interlayer insulating layer 207 may each have a single layer structure or a multilayer structure.

The pixel circuit PC including the thin film transistor TFT and the storage capacitor Cst may be covered by a first organic insulating layer 209.

The pixel circuit PC may be electrically connected to the first pixel electrode 221R. For example, as illustrated in FIG. 7, the contact metal layer CM may be provided or arranged between the thin film transistor TFT and the first pixel electrode 221R. The contact metal layer CM may be connected to the thin film transistor TFT through a contact hole formed or arranged in the first organic insulating layer 209, and the first pixel electrode 221R may be connected to the contact metal layer CM through a contact hole formed or arranged in a second organic insulating layer 211 arranged on the first organic insulating layer 209 to cover the contact metal layer CM. The contact metal layer CM may include a conductive (e.g., electrically conductive) material including Mo, Al, Cu, and/or Ti and may have a multilayer structure or a single layer structure. For example, the contact metal layer CM may have a multilayer structure of a Ti layer, an Al layer, and a Ti layer (Ti/Al/Ti).

The first organic insulating layer 209 and the second organic insulating layer 211 may include an organic insulating (e.g., electrically insulating) material, such as acryl, polystyrene (PS), polymethylmethacrylate (PMMA), benzocyclobutene (BCB), polyimide, and/or hexamethyldisiloxane (HMDSO). For example, the first organic insulating layer 209 and the second organic insulating layer 211 may each include polyimide. The first organic insulating layer 209 and/or the second organic insulating layer 211 may each have an approximately flat upper surface. For example, the second organic insulating layer 211 may be a planarization layer.

The display element 220 that is a light-emitting element may be arranged on the second organic insulating layer 211 that is a planarization layer. In FIG. 7, for convenience of explanation, the display element 220 capable of emitting red light is illustrated. The display element 220 capable of emitting red light may include a reflective plate 224, the first pixel electrode 221R, a first function layer 222a, a first emission layer 222bR, a second function layer 222c, and/or a common electrode 223.

The reflective plate 224 arranged on the second organic insulating layer 211 may be to reflect light incident on the reflective plate 224. The reflective plate 224 may include, for example, Ag, Mg, Al, Pt, Pd, Au, Ni, Nd, Ir, Cr, or compounds thereof, and may be formed by a sputtering method. The reflective plate 224 may appear to have an isolated shape in plan view.

A thickness adjustment layer 213 may be arranged on the reflective plate 224. For example, the thickness adjustment layer 213 may be arranged on the second organic insulating layer 211 to cover the reflective plate 224. The first pixel electrode 221R may be arranged on the thickness adjustment layer 213. Consequently, the thickness adjustment layer 213 may be to adjust a distance (e.g. define a specific distance) between the reflective plate 224 and the first pixel electrode 221R. The thickness adjustment layer 213 may include an organic insulating (e.g., electrically insulating) material, such as acryl, PS, PMMA, BCB, polyimide, and/or HMDSO. The thickness adjustment layer 213 may have an approximately flat upper surface.

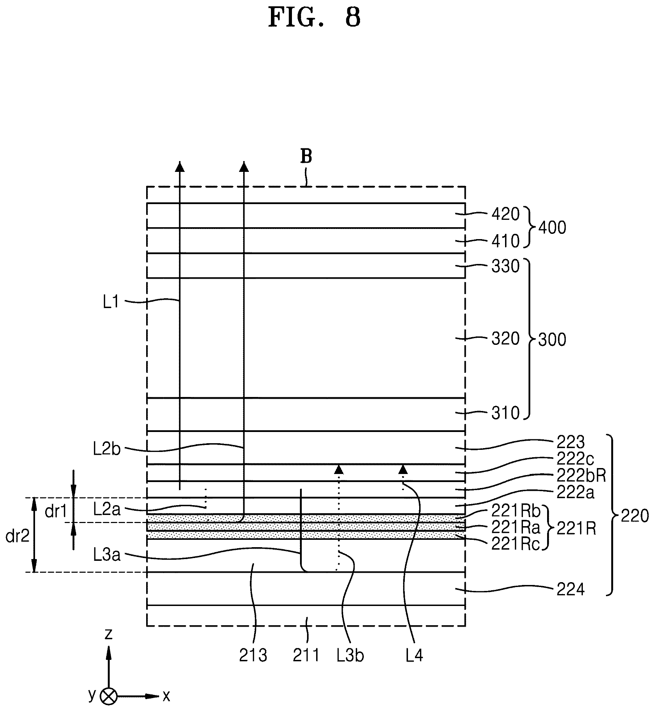

The first pixel electrode 221R may be arranged on the thickness adjustment layer 213. The first pixel electrode 221R may include a chiral metasurface reflector 221Ra (see FIG. 8). The first pixel electrode 221R may have an isolated shape in plan view. The first pixel electrode 221R may correspond to (e.g. disposed on) the reflective plate 224 thereunder. For example, at least part of the first pixel electrode 221R may overlap the reflective plate 224 thereunder in plan view.

The first pixel electrode 221R may be electrically connected to the thin film transistor TFT by being connected to the contact metal layer CM under the second organic insulating layer 211 through a contact hole formed or arranged in the thickness adjustment layer 213 and the second organic insulating layer 211. To this end, the first pixel electrode 221R may extend to the outside of the reflective plate 224 in plan view. The first pixel electrode 221 may be connected to the contact metal layer CM under the second organic insulating layer 211 through the contact hole. A more detailed structure of the first pixel electrode 221R is described herein.

A pixel-defining layer 215 may be arranged (e.g. disposed) on the thickness adjustment layer 213. The pixel-defining layer 215 may prevent generation of an arc (or to reduce a degree or occurrence of generation of an arc) at the edge of the first pixel electrode 221R by increasing the distance between the first pixel electrode 221R and the common electrode 223 thereabove by covering the edge of the first pixel electrode 221R. For example, the pixel-defining layer 215 having an opening may expose the center portion of the first pixel electrode 221R. The pixel-defining layer 215 may be formed or composed of one or more organic insulating (e.g., electrically insulating) materials selected from among polyimide, polyamide, an acrylic resin, benzocyclobutene, and a phenol resin, by spin coating. In one or more embodiments, the pixel-defining layer 215 may include an inorganic insulating (e.g., electrically insulating) material, such as silicon nitride (e.g., SiNₓ, wherein 0 < x ≤ 2; e.g., Si₃N₄), silicon oxynitride (e.g., SiOₓN_{y}, wherein 0 < x ≤ 2 and 0 < y ≤ 2; e.g., SiON or Si₂N₂O), and/or silicon oxide (e.g., SiO_{X}, wherein 0 < x ≤ 2; e.g., SiO₂).

As described in one or more embodiments, at least part of the first pixel electrode 221R may overlap (disposed on) the reflective plate 224 thereunder in plan view. As illustrated in FIG. 7, the part of the first pixel electrode 221R, exposed by the opening of the pixel-defining layer 215, may overlap the reflective plate 224 thereunder in plan view. For example, the part of the first pixel electrode 221R, exposed by the opening of the pixel-defining layer 215, may be positioned within the reflective plate 224 thereunder in plan view.

An intermediate layer between the first pixel electrode 221R and the common electrode 223 may include the first emission layer 222bR. The intermediate layer may include the first function layer 222a arranged between the first emission layer 222bR and the first pixel electrode 221R, and the second function layer 222c arranged between the first emission layer 222bR and the common electrode 223. The first emission layer 222bR may be to emit light of a certain (e.g., set or predetermined) color and may include a high molecular weight organic material (e.g., a polymer) and/or a low molecular weight organic material. As illustrated in FIG. 7, the first emission layer 222bR may be to emit, for example, red light but may emit other colors in other embodiments.

The first function layer 222a may be a single layer or a multilayer. For example, if (e.g., when) the first function layer 222a includes a polymer material, the first function layer 222a may be a hole transport layer (HTL) that is a single layer structure and may include poly-(3,4-ethylene-dihydroxy thiophene) (PEDOT) and/or polyaniline (PANI). If (e.g., when) the first function layer 222a includes a low-molecular weight material, the first function layer 222a may include a hole injection layer (HIL) and a hole transport layer (HTL).

The second function layer 222c may include an electron transport layer (ETL) and/or an electron injection layer (EIL).

The intermediate layer may be modified according to embodiments of the disclosure. For example, the intermediate layer may include a first stack including the first emission layer 222bR, the first function layer 222a, and the second function layer 222c, a second stack including the first emission layer 222bR, the first function layer 222a, and the second function layer 222c, and a charge generation layer between the first stack and the second stack. The charge generation layer may include a negative charge generation layer and a positive charge generation layer. For a tandem-type (kind) light-emitting diode (LED) including the first emission layers 222bR, luminous efficiency may be further increased or enhanced by the negative charge generation layer and the positive charge generation layer.

The negative charge generation layer may be a negative type (kind) (e.g., n-type (kind)) charge generation layer. The negative charge generation layer may be to supply electrons. The negative charge generation layer may include a host and a dopant. The host may include an organic material. The dopant may include a metal material. The positive charge generation layer may be a positive type (kind) (e.g., p-type (kind)) charge generation layer. The positive charge generation layer may be to supply holes. The positive charge generation layer may include a host and a dopant. The host may include an organic material. The dopant may include a metal material.

As illustrated in FIG. 7, the first emission layer 222bR may be patterned to correspond to the first pixel electrode 221R. For example, the first emission layer 222bR may have an isolated shape to correspond to the first pixel electrode 221R. One or more suitable modifications are feasible such that each of the first function layer 222a and/or the second function layer 222c may be integrally formed or arranged as an indivisible single body over a plurality of pixel electrodes.

The common electrode 223 arranged on the intermediate layer may be a light-transmissive electrode or a semi-light transmissive electrode. For example, the common electrode 223 may include a metal thin film with a low work function including lithium (Li), calcium (Ca), aluminum (Al), silver (Ag), magnesium (Mg), or compounds thereof (e.g., LiF). Furthermore, the common electrode 223 may further include a transparent (e.g., substantially transparent) conductive (e.g., electrically conductive) oxide (TCO) film, such as indium tin oxide (ITO), indium zinc oxide (IZO), zinc oxide (e.g., ZnOₓ, wherein 0 < x ≤ 2; e.g., ZnO or ZnO₂), or indium oxide (e.g., In₂O₃), arranged on the metal thin film.

The common electrode 223 may be integrally formed or arranged to cover the display area DA across the whole surface of the display area DA and may be arranged above the intermediate layer and the pixel-defining layer 215. For example, the common electrode 223 may integrally correspond to a plurality of organic light-emitting diodes OLEDs. The organic light-emitting diodes OLEDs may share the common electrode 223, and a stack structure of the first pixel electrode 221R, the intermediate layer, and the common electrode 223 may correspond to each organic light-emitting diode OLED.

A capping layer may be arranged on the common electrode 223. The capping layer may include, for example, LiF. The capping layer may not be provided.

The display element 220, such as an organic light-emitting diode, may be covered by the thin-film encapsulation layer 300. If (e.g., when) the capping layer exits, the thin-film encapsulation layer 300 may be arranged on the capping layer. The thin-film encapsulation layer 300 may include at least one organic encapsulation layer and at least one inorganic encapsulation layer, and FIG. 7 illustrates that the thin-film encapsulation layer 300 includes a first inorganic encapsulation layer 310, a second inorganic encapsulation layer 330, and an organic encapsulation layer 320 between the first inorganic encapsulation layer 310 and the second inorganic encapsulation layer 330. The numbers and a stack order of organic encapsulation layers and inorganic encapsulation layers may be changed.

The first inorganic encapsulation layer 310 and the second inorganic encapsulation layer 330 may each include one or more inorganic materials selected from among aluminum oxide (e.g., AlOₓ, wherein 0 < x ≤ 2; e.g., Al₂O₃), titanium oxide (e.g., TiOₓ, wherein 0 < x ≤ 2; e.g., TiO₂), tantalum oxide (e.g., TaOₓ, wherein 0 < x ≤ 3; e.g., Ta₂O₅), hafnium oxide (e.g., HfO₂), zinc oxide (e.g., ZnOₓ, wherein 0 < x ≤ 2; e.g., ZnO or ZnO₂), silicon oxide (e.g., SiO_{X}, wherein 0 < x ≤ 2; e.g., SiO₂), silicon nitride (e.g., SiNₓ, wherein 0 < x ≤ 2; e.g., Si₃N₄), and silicon oxynitride (e.g., SiOₓN_{y}, wherein 0 < x ≤ 2 and 0 < y ≤ 2; e.g., SiON or Si₂N₂O). The first inorganic encapsulation layer 310 and the second inorganic encapsulation layer 330 may each have a single layer structure or a multilayer structure. The organic encapsulation layer 320 may include a polymer-based material. The polymer-based material may include an acrylic resin, such as polymethylmethacrylate and/or polyacrylic acid, an epoxy-based resin, polyimide, and/or polyethylene. For example, the organic encapsulation layer 320 may include acrylate.

The first inorganic encapsulation layer 310 and the second inorganic encapsulation layer 330 may include different materials. For example, the first inorganic encapsulation layer 310 may include silicon oxynitride (e.g., SiOₓN_{y}, wherein 0 < x ≤ 2 and 0 < y ≤ 2; e.g., SiON or Si₂N₂O), and the second inorganic encapsulation layer 330 may include silicon nitride (e.g., SiNₓ, wherein 0 < x ≤ 2; e.g., Si₃N₄).

The first inorganic encapsulation layer 310 may have a curved portion along the shape of the common electrode 223. The organic encapsulation layer 320 may have an upper surface having an approximately flat shape, and accordingly, the second inorganic encapsulation layer 330 may also have an approximately flat shape.

The anti-reflection layer 400 may be arranged on the thin-film encapsulation layer 300. The anti-reflection layer 400 may be to prevent reflection of external light (or reduce a degree or occurrence of reflection of external light) inside the display panel 10 and/or on the display panel 10. The anti-reflection layer 400 may include the linear polarization plate 420 and the λ/4 phase retardation plate 410. Of the external light incident on the display panel 10, light that is linearly polarized in a specific direction may pass through the linear polarization plate 420. For example, incident light having a polarization of directions other than the specific direction may not pass through the linear polarization plate 420. The light passing the linear polarization plate 420 may be changed by the λ/4 phase retardation plate 410 into light in a state of one among left-circularly polarization and right-circularly polarization. For example, if (e.g., when) the light having passed through the linear polarization plate 420 is changed by the λ/4 phase retardation plate 410 into left-circularly polarized light, the light may be reflected on the first pixel electrode 221R, and the light may be incident on the λ/4 phase retardation plate 410 from below in a right-circularly polarization state if (e.g., when) viewed in a traveling direction of the light. Accordingly, the light passing through the λ/4 phase retardation plate 410 again may be changed to linearly polarized light, which is in a linearly polarized state of a direction such that the linearly polarized light is unable to pass through the linear polarization plate 420. In other words, the incident light may (then) have a polarization other than the specific direction for passing so that the light may not pass through the linear polarization plate 420. Consequently, the external light incident on the display panel 10 may not be reflected to the outside, and thus the anti-reflection layer 400 may have the function to reduce the reflection of external light. Accordingly, the visibility of an image display by the display panel 10 may be improved or enhanced.

If (e.g., when) necessary or desired, a touch screen layer may be positioned or arranged between the thin-film encapsulation layer 300 and the anti-reflection layer 400, or on the anti-reflection layer 400.

FIG. 8 is an enlarged schematic cross-sectional view of region B of FIG. 7. In FIG. 8, illustrated is a layer structure of the first pixel electrode 221R. As illustrated in the drawing, the first pixel electrode 221R includes a chiral metasurface reflector 221Ra. The chiral metasurface reflector 221Ra may transmit (e.g., any one selected from) left-circularly polarized light and right-circularly polarized light while reflecting the other one among the left-circularly polarized light or right-circularly polarized light. E.g., the chiral metasurface reflector 221Ra may be configured and/or arranged to transmit either left-circularly polarized light or right-circularly polarized light and to reflect the opposite circularly polarized light (e.g., the circularly polarized light of opposite (the other) handedness). For example, if (e.g., when) the chiral metasurface reflector 221Ra transmits left-circularly polarized light, it may reflect right-circularly polarized light. If (e.g., when) it transmits right-circularly polarized light, it may reflect left-circularly polarized light. In the following description, for convenience of explanation, for light traveling in a -z direction to be incident on the chiral metasurface reflector 221Ra, a case of transmitting left-circularly polarized light while reflecting right-circularly polarized light is described. For reference, although FIG. 8 illustrates, for convenience of explanation, that an upper surface of the chiral metasurface reflector 221Ra is a flat layer, the shape of the chiral metasurface reflector 221Ra may be suitably modified, which is described herein in more detail.

The first pixel electrode 221R may further include other layers in addition to the chiral metasurface reflector 221Ra. For example, the first pixel electrode 221R may further include a first oxide conductor 221Rb between the chiral metasurface reflector 221Ra. For example, the first pixel electrode 221R may include the intermediate layer and/or a second oxide conductor 221Rc between the chiral metasurface reflector 221Ra and the thickness adjustment layer 213.

The first oxide conductor 221Rb and/or the second oxide conductor 221Rc may be transparent or semi-transparent electrode layer. The transparent or semi-transparent electrode layer may include at least one selected from among ITO, IZO, zinc oxide (e.g., ZnOₓ, wherein 0 < x ≤ 2; e.g., ZnO or ZnO₂), indium oxide (e.g., In₂O₃), indium gallium oxide (IGO), and aluminum zinc oxide (AZO). For example, the first pixel electrode 221R may have a three-layer structure of an ITO layer, the chiral metasurface reflector 221Ra, and an ITO layer. The first oxide conductor 221Rb and/or the second oxide conductor 221Rc may be formed by a sputtering method.

As described in one or more embodiments, the anti-reflection layer 400 may include the linear polarization plate 420 and the λ/4 phase retardation plate 410. According to the embodiments of the disclosure, the external light incident on the display panel 10 may be prevented from being reflected by the display panel 10 (or a degree to or occurrence of which the external light incident on the display panel 10 is reflected by the display panel 10 may be reduced) or the degree of the reflection of the external light may be reduced. In the display device according to the present disclosure, as most (e.g., substantially all) of the light generated from the first emission layer 222bR and passing through the common electrode 223 is made to pass through the anti-reflection layer 400, the light extraction efficiency of the display panel 10 and the electronic apparatus 1 including the display panel 10 may be improved or enhanced, which is described herein in more detail.

In FIG. 8, a traveling path of the light generated in the first emission layer 222bR is schematically illustrated. An optical path indicated by a solid line denotes a path of left-circularly polarized light if (e.g., when) viewed in a light traveling direction, and an optical path indicated by a dotted line denotes a path of right-circularly polarized light if (e.g., when) viewed in the light traveling direction. Both (e.g., sequentially, concurrently, or simultaneously) of the left-circularly polarized light and the right-circularly polarized light may be generated in the first emission layer 222bR. In the following description, for convenience of explanation, a case in which, of left-circularly polarized light and right-circularly polarized light incident on an upper surface of the chiral metasurface reflector 221Ra, the chiral metasurface reflector 221Ra transmits the left-circularly polarized light and reflects the right-circularly polarized light is described in more detail.

Of the left-circularly polarized light generated in the first emission layer 222bR, light L1 traveling in a direction (+z direction) toward the common electrode 223 (or toward an (emission) area of the display panel) may sequentially pass through the λ/4 phase retardation plate 410 and the linear polarization plate 420 and may be output to the outside of the display panel 10.

Of the right-circularly polarized light generated in the first emission layer 222bR, light L2a traveling in a direction (-z direction) toward the first pixel electrode 221R may, e.g. by passing through the first oxide conductor 221Rb of the first pixel electrode 221R, be incident on the chiral metasurface reflector 221Ra of the first pixel electrode 221R. As the chiral metasurface reflector 221Ra transmits the left-circularly polarized light and reflects the right-circularly polarized light, the right-circularly polarized light L2a incident on the chiral metasurface reflector 221Ra may be reflected by the chiral metasurface reflector 221Ra. Light L2b reflected as described herein may become left-circularly polarized light if (e.g., when) viewed in the light traveling direction (+z direction), and thus, may sequentially pass through the λ/4 phase retardation plate 410 and the linear polarization plate 420 and may be output to the outside of the display panel 10.

In this state, by increasing intensity of light using constructive interference between the light L2b and the light L1, light extraction efficiency may be further improved or enhanced. As the phases of the light L2b and the light L1 are substantially the same, in order to generate constructive interference between the light L2b and the light L1, the path difference between the light L2b and the light L1 is desired to be an even multiple of half the wavelength.

If (e.g., when) the distance between the chiral metasurface reflector 221Ra and the first emission layer 222bR is dr1 (e.g. d1), the path difference between the light L2b and the light L1 may be double dr1 (e.g. double d1). Accordingly, if (e.g., when) the wavelength of the light emitted from the first emission layer 222bR is λ_{R} (e.g. λ) and n is a natural number, the distance dr1 (e.g. d1) between the chiral metasurface reflector 221Ra and the first emission layer 222bR may be such that (e.g., may be defined as) dr1=nλ_{R}/2 (e.g. d=n λ/2). For example, it may be that, if (e.g., when) n=1, dr1=λ_{R}/2 (e.g. d= λ/2). The distance as described herein may be controlled or selected by adjusting the thickness of the first function layer 222a between the first emission layer 222bR and the first pixel electrode 221R. For reference, the distance dr1 (e.g. d1) between the chiral metasurface reflector 221Ra and the first emission layer 222bR may be a distance between the upper surface of the chiral metasurface reflector 221Ra in the direction (+z direction) toward the common electrode 223 (e.g. toward an (emission) area of the display panel) and the lower surface of the first emission layer 222bR in the direction (-z direction) toward the first pixel electrode 221R.

Of the left-circularly polarized light generated in the first emission layer 222bR, light L3a traveling in the direction (-z direction) toward the first pixel electrode 221R may, e.g. pass through the first oxide conductor 221Rb of the first pixel electrode 221R, be incident on the chiral metasurface reflector 221Ra of the first pixel electrode 221R. As the chiral metasurface reflector 221Ra transmits the left-circularly polarized light and reflects the right-circularly polarized light, the left-circularly polarized light L3a incident on the chiral metasurface reflector 221Ra may pass through the chiral metasurface reflector 221Ra and may be reflected on the reflective plate 224 thereunder. Light L3b reflected as described herein may become right-circularly polarized light if (e.g., when) viewed in the light traveling direction (+z direction) and may be incident on the chiral metasurface reflector 221Ra. The structure of the chiral metasurface reflector 221Ra viewed from +z direction may be opposite to the structure of the chiral metasurface reflector 221Ra viewed from the -z direction, as described herein in more detail. Accordingly, if (e.g., when) the light traveling in the +z direction is incident on the lower surface of the chiral metasurface reflector 221Ra, the chiral metasurface reflector 221Ra may be to transmit the right-circularly polarized light and reflect the left-circularly polarized light. Accordingly, as the light L3b reflected from the reflective plate 224 is right-circularly polarized light if (e.g., when) viewed in the light traveling direction (+z direction), the light L3b may travel in the +z direction by sequentially passing through the chiral metasurface reflector 221Ra. The light L3b may pass the common electrode 223.

Light L4 in traveling in the direction (+z direction) of the light emitting surface, e.g. toward the common electrode 223 (e.g. toward an (emission) area of the display panel), among the right-circularly polarized light generated in the first emission layer 222bR, may have (e.g. substantially) the same phase as the light L3b in traveling in the direction (+z direction), e.g. toward the common electrode 223, after being reflected on the reflective plate 224 as described in one or more embodiments. Accordingly, in order to prevent the light L4 and the light L3b from entering the anti-reflection layer 400 (or to reduce a degree to or occurrence of which the light L4 and the light L3b enter the anti-reflection layer 400) or reduce the amount of light entering the anti-reflection layer 400, there is a need or desire to decrease the intensity of the light through destructive interference between the light L4 and the light L3b. As the phases of the light L4 and the light L3b are substantially the same, in order to generate destructive interference between the light L4 and the light L3b, the path difference of the light L4 and the light L3b is desired to be an odd multiple of half the wavelength.

If (e.g., when) the distance between the reflective plate 224 and the first emission layer 222bR is dr2 (e.g. d2), the path difference of the light L4 and the light L3b may be double dr2 (e.g. double d2). Accordingly, if (e.g., when) the wavelength of the light emitted from the first emission layer 222bR is λ_{R} (e.g. λ) and k is 0 or a natural number, the distance dr2 (e.g. d) between the reflective plate 224 and the first emission layer 222bR may be such that (e.g., may be defined as) dr2=(2k+1)λ_{R}/4 (e.g. d2=(2k+1)λ/4). For example, it may be that, if (e.g., when) k=0, dr2=λ_{R}/4 (e.g. d2=λ/4). The distance as described herein may be controlled and/or selected (e.g. set) by adjusting the thickness of the thickness adjustment layer 213 between the reflective plate 224 and the first pixel electrode 221R. For reference, the distance dr2 between the reflective plate 224 and the first emission layer 222bR may be a distance between the upper surface of the reflective plate 224 in the direction (+z direction) toward the common electrode 223 and the lower surface of the first emission layer 222bR in the direction (-z direction) toward the first pixel electrode 221R.

In the display panel 10 and the electronic apparatus 1 including the display panel 10 according to the present disclosure, most (e.g., substantially all) of the light generated from the first emission layer 222bR and passing through the common electrode 223 may be made to pass through the anti-reflection layer 400 to be emitted to the outside. Thus, the display panel 10 with high efficiency and the electronic apparatus 1 including the display panel 10 may be implemented.

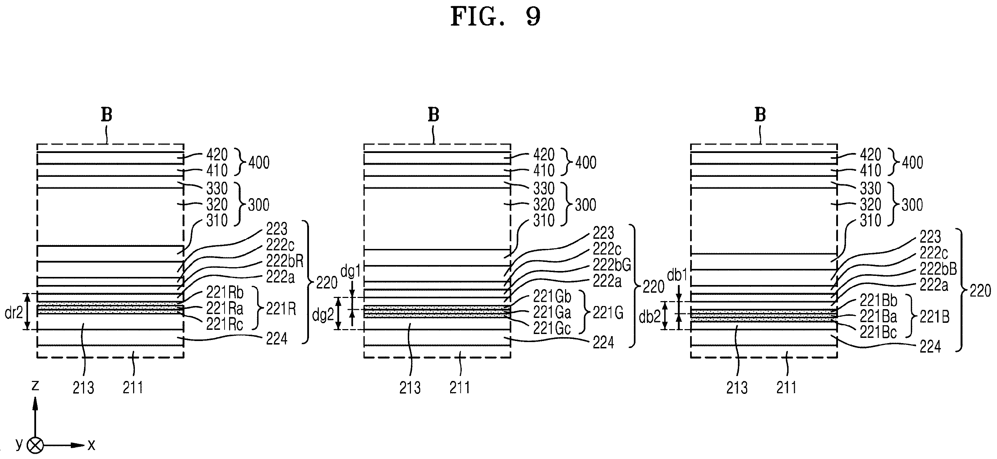

Although FIGS. 7 and 8 illustrate a pixel emitting red light, the same/similar content (e.g., amount) may be applied to pixels emitting light of different colors. FIG. 9 is a schematic cross-sectional view of parts of the display panel 10 according to one or more embodiments. FIG. 9 illustrates that the first pixel electrode 221R and the first emission layer 222bR are arranged in a pixel to emit red light, as described in one or more embodiments, a second pixel electrode 221G and a second emission layer 222bG are similarly arranged in a pixel to emit green light, and a third pixel electrode 221B and a third emission layer 222bB are similarly arranged in a pixel to emit blue light. The second emission layer 222bG may be an emission layer that is to emit green light, and the third emission layer 222bB may be an emission layer that is to emit blue light.

The configuration or arrangement of each of the second pixel electrode 221G and the third pixel electrode 221B may be similar to the configuration or arrangement of the first pixel electrode 221R as described in one or more embodiments. For example, the second pixel electrode 221G may include a chiral metasurface reflector 221Ga, and furthermore, the second pixel electrode 221G may include a first oxide conductor 221Gb between the chiral metasurface reflector 221Ga and the intermediate layer and/or a second oxide conductor 221Gc between the chiral metasurface reflector 221Ga and the thickness adjustment layer 213. For example, the second pixel electrode 221G may have a three-layer structure of an ITO layer, the chiral metasurface reflector 221Ga, and an ITO layer. The third pixel electrode 221B may include a chiral metasurface reflector 221Ba, and furthermore, the third pixel electrode 221B may include a first oxide conductor 221Bb between the chiral metasurface reflector 221Ba and the intermediate layer and/or a second oxide conductor 221Bc between the chiral metasurface reflector 221Ba and the thickness adjustment layer 213. For example, the third pixel electrode 221B may have a three-layer structure of an ITO layer, the chiral metasurface reflector 221Ba, and an ITO layer.

If (e.g., when) the wavelength of the light emitted from the second emission layer 222bG is λ_{G} and n is a natural number, a distance dg1 between the chiral metasurface reflector 221Ga and the second emission layer 222bG may be such that (e.g., may be defined as) dg1=nλ_{G}/2. For example, it may be that, if (e.g., when) n=1, dg1=λ_{G}/2. The distance as described herein may be controlled and/or selected (e.g. set) by adjusting (e.g. setting) the thickness of the first function layer 222a between the second emission layer 222bG and the second pixel electrode 221G. For reference, the distance dg1 between the chiral metasurface reflector 221Ga and the second emission layer 222bG may be a distance between the upper surface of the chiral metasurface reflector 221Ga in the direction (+z direction) toward the common electrode 223 and the lower surface of the second emission layer 222bG in a direction (-z direction) toward the second pixel electrode 221G. If (e.g., when) k is 0 or a natural number, a distance dg2 between the reflective plate 224 and the second emission layer 222bG may be such that (e.g., may be defined as) dg2=(2k+1)λ_{G}/4. For example, it may be that, if (e.g., when) k=0, dg2=λG/4. The distance as described herein may be controlled and/or selected (e.g. set) by adjusting (e.g. setting) the thickness of the thickness adjustment layer 213 between the reflective plate 224 and the second pixel electrode 221G. For reference, the distance dg2 between the reflective plate 224 and the second emission layer 222bG may be a distance between the upper surface of the reflective plate 224 in the direction (+z direction) toward the common electrode 223 and the lower surface of the second emission layer 222bG in the direction (-z direction) toward the second pixel electrode 221G.

If (e.g., when) the wavelength of the light emitted from the third emission layer 222bB is λ_{B} and n is a natural number, a distance db1 between the chiral metasurface reflector 221Ba and the third emission layer 222bB may be such that (e.g., may be defined as) db1=nλ_{B}/2. For example, it may be that, if (e.g., when) n=1, db1=λ_{B}/2. The distance as described herein may be controlled and/or selected by adjusting the thickness of the first function layer 222a between the third emission layer 222bB and the third pixel electrode 221B. For reference, the distance db1 between the chiral metasurface reflector 221Ba and the third emission layer 222bB may be a distance between the upper surface of the chiral metasurface reflector 221Ba in the direction (+z direction) toward the common electrode 223 and the lower surface of the third emission layer 222bB in a direction (-z direction) toward the third pixel electrode 221B. If (e.g., when) k is 0 or a natural number, a distance db2 between the reflective plate 224 and the third emission layer 222bB may be such that (e.g., may be defined as) db2=(2k+1)λ_{B}/4. For example, it may be that, if (e.g., when) k=0, db2=λ_{B}/4. The distance as described herein may be controlled and/or selected by adjusting the thickness of the thickness adjustment layer 213 between the reflective plate 224 and the third pixel electrode 221B. For reference, the distance db2 between the reflective plate 224 and the third emission layer 222bB may be a distance between the upper surface of the reflective plate 224 in the direction (+z direction) toward the common electrode 223 and the lower surface of the third emission layer 222bB in the direction (-z direction) toward the third pixel electrode 221B.

In the case of the display panel 10 according to the present disclosure and the electronic apparatus 1 including the display panel 10, in each of the pixel to emit red light, the pixel to emit green light, and the pixel to emit blue light, most (e.g., substantially all) of the light generated from the emission layer and passing through the common electrode 223 may be made to pass through the anti-reflection layer 400 to be emitted to the outside. Accordingly, the display panel 10 with high efficiency and the electronic apparatus 1 including the display panel 10 may be implemented. For reference, as λ_{R}>λ_{G}>λ_{B}, as illustrated in FIG. 9, it may be dr2>dg2>db2. In FIG. 9, for convenience of explanation, the thickness of the first function layer 222a is illustrated to be substantially identical in each of the pixel to emit red light, the pixel to emit green light, and the pixel to emit blue light, and dr1>dg1>db1. λ_{R} may be in a range of 610 nm to 750 nm, for example, 656 nm, and λ_{G} may be in a range of 495 nm to 570 nm, for example, 555 nm, and λ_{B} may be in a range of 450 nm to 495 nm, for example, 454 nm.

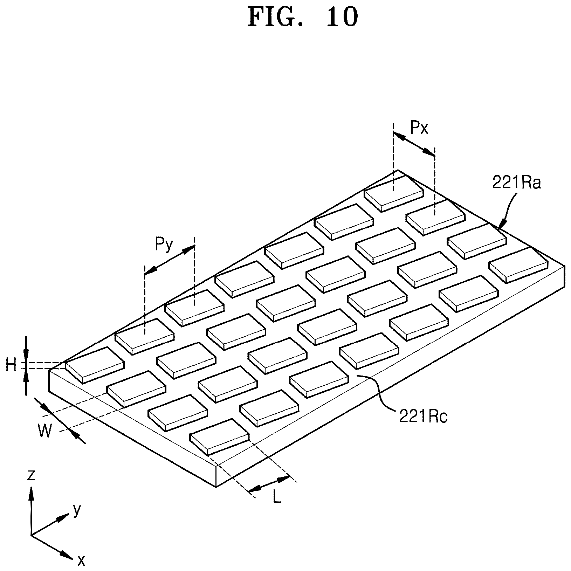

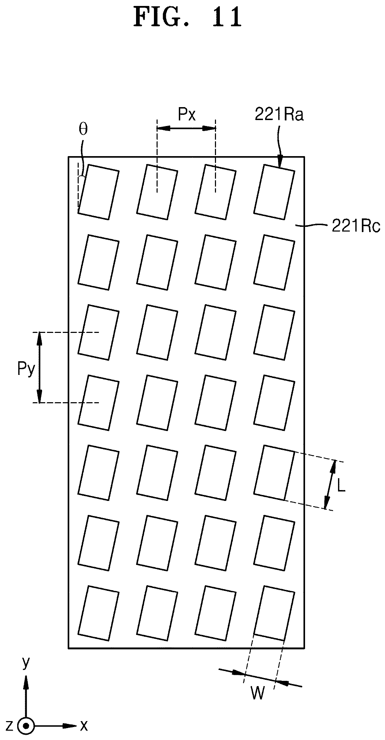

FIG. 10 is a schematic perspective view of the chiral metasurface reflector 221Ra of the display panel 10 according to one or more embodiments and the electronic apparatus 1 including the display panel 10. FIG. 11 is a schematic plan view of the chiral metasurface reflector 221Ra of FIG. 10. In the following description, for convenience of explanation, although the chiral metasurface reflector 221Ra in the first pixel electrode 221R is described in more detail, the content (e.g., amount) as described herein may be applied to the chiral metasurface reflector 221Ga in the second pixel electrode 221G or the chiral metasurface reflector 221Ba in the third pixel electrode 221B.

As illustrated in FIG. 10, the chiral metasurface reflector 221Ra may have a structure in which a plurality of pieces in a flat shape having a regular size are arranged at regular intervals. In FIG. 10, the chiral metasurface reflector 221Ra is illustrates as having a structure in which pieces in a flat shape (e.g., a substantially flat shape) are arranged at regular intervals on the second oxide conductor 221Rc arranged on the thickness adjustment layer 213. The pieces in a flat shape as described herein may be referred as nano antennas. For reference, the first oxide conductor 221Rb arranged on the chiral metasurface reflector 221Ra may cover the pieces in a flat shape (e.g., a substantially flat shape) as illustrated in FIG. 10 and may be in contact with the second oxide conductor 221Rc between the pieces in a flat shape (e.g., a substantially flat shape).

The nano antennas may be arranged such that a center spacing in the first direction (x-axis direction) is Px and a center spacing in the second direction (y-axis direction) is Py. Each of the nano antennas may have a rectangular shape (e.g., a substantially rectangular shape) with a height H, and a width W and a length L in plan view. In each of the nano antennas, in plan view, an edge (e.g., a side) in the longitudinal direction may form, for example, a preset angle θ with respect to the second direction (y-axis direction).

By adjusting parameters, for example, H, W, L, Px, Py, and/or θ, for the nano antennas, any one selected from the left-circularly polarized light and the right-circularly polarized light, which are incident on the nano antennas, may be reflected, and the other may be transmitted (e.g., may be configured or arranged to transmit either left-circularly polarized light or right-circularly polarized light and to reflect the opposite circularly polarized light). Furthermore, it may also be feasible to control which wavelength of light the chiral metasurface reflector 221Ra will have the properties for.

For example, H may be 30 nm, W may be 60 nm, L may be 114 nm, Px may be 108 nm, Py may be 162 nm, and θ=25 degrees. The nano antennas may include, for example, one of Ag, Mg, Al, Pt, Pd, Au, Ni, Nd, Ir, Cr, or compounds thereof, and the first oxide conductor 221Rb and/or the second oxide conductor 221Rc may have a thickness of 10 nm and include ITO.

For reference, the arrangement of the chiral metasurface reflector 221Ra if (e.g., when) the light traveling in the -z direction is incident on the upper surface of the chiral metasurface reflector 221Ra may be opposite to the arrangement of the chiral metasurface reflector 221Ra if (e.g., when) the light traveling in the +z direction is incident on the lower surface of the chiral metasurface reflector 221Ra. Accordingly, if (e.g., when) the chiral metasurface reflector 221Ra, for example, transmits the left-circularly polarized light and reflects the right-circularly polarized light for the light that travels in the -z direction to be incident on the upper surface of the chiral metasurface reflector 221Ra, the chiral metasurface reflector 221Ra may be to transmit the right-circularly polarized light and reflect the left-circularly polarized light for the light that travels in the +z direction to be incident on the lower surface of the chiral metasurface reflector 221Ra.

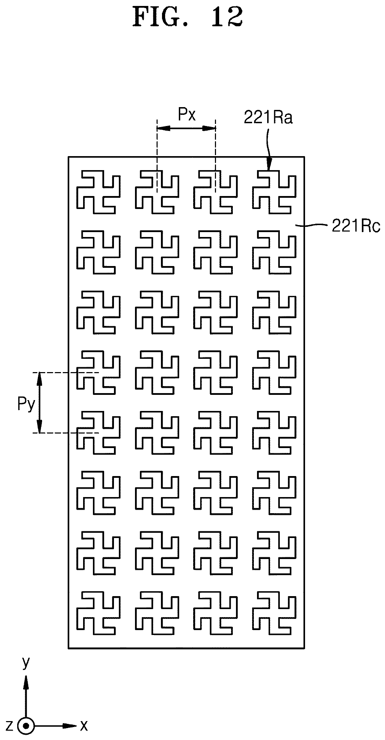

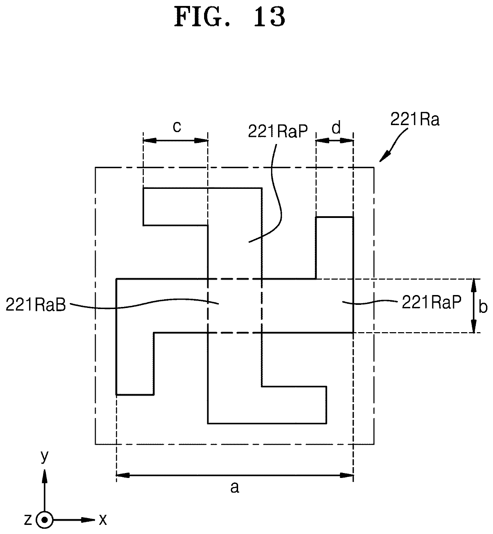

The shape of the chiral metasurface reflector 221Ra is not limited to the illustrations of FIGS. 10 and 11. FIG. 12 is a schematic plan view of the chiral metasurface reflector 221Ra of the display panel 10 according to one or more embodiments and the electronic apparatus including the display panel 10. FIG. 13 is an enlarged plan view of a part of the chiral metasurface reflector 221Ra of FIG. 12.

As illustrated in FIGS. 12 and 13, the nano antennas may be arranged such that a center spacing in the first direction (x-axis direction) is Px and a center spacing in the second direction (y-axis direction) is Py. Each of the nano antennas may include a body portion 221RaB and a plurality of prong portions 221RaP. The prong portions 221RaP may have a shape extending from the body portion 221RaB in a radial direction. Each of the prong portions 221RaP may have a bent shape as illustrated in FIGS. 12 and 13. FIG. 12 illustrates that each nano antenna has four prong portions 221RaP, and that each of the prong portions 221RaP has a shape bent once.

By adjusting a length b of a side of the body portion 221RaB that appears in a square shape (e.g., a substantially square shape) in plan view, a length a from a portion of any one prong portion 221RaP before bending to a portion of another prong portion 221RaP before bending at the opposite side via the body portion 221RaB, a length c of a portion of the prong portion 221RaP after bending, and/or a width d of a portion of the prong portion 221RaP after bending, any one selected from the left-circularly polarized light and the right-circularly polarized light incident on the chiral metasurface reflector 221Ra may be to transmit the chiral metasurface reflector 221Ra and the other may be reflected from the chiral metasurface reflector 221Ra. Furthermore, it is also feasible to control which wavelength of light the chiral metasurface reflector 221Ra may have the properties for.

In the present disclosure, the structure of the display panel 10 is mainly or predominantly described, but embodiments of the present disclosure are not limited thereto. The electronic apparatus 1 including the display panel 10 may also said to fall within the scope of the present disclosure.

According to one or more embodiments of the present disclosure, a display panel in which efficiency of light generated from an emission layer and emitted to the outside may be high (e.g., increased or enhanced) and an electronic apparatus including the display panel may be implemented. The scope of embodiments of the present disclosure is not limited by the above effects.

It should be understood that embodiments described herein should be considered in a descriptive sense only and not for purposes of limitation. Descriptions of features or aspects within each embodiment should typically be considered as available for other similar features or aspects in other embodiments. While the subject matter of the present disclosure has been described with reference to the drawings, it will be understood by those of ordinary skill in the art that one or more suitable changes in form and more details may be made therein.

## Claims

1. A display panel (10) comprising:
a substrate (100);
a pixel electrode (221R, 221G, 221B) on the substrate (100), the pixel electrode (221R, 221G, 221B) comprising a chiral metasurface reflector (221Ba, 221Ga, 221Ra);
a reflective plate (224) between the substrate (100) and the pixel electrode (221R, 221G, 221B);
a thickness adjustment layer (213) between the reflective plate (224) and the pixel electrode (221R, 221G, 221B); and
an emission layer (222bR, 222bG, 222bB) on the pixel electrode (221R, 221G, 221B).

2. The display panel (10) as claimed in claim 1, wherein the chiral metasurface reflector (221Ba, 221Ga, 221Ra) is configured to:
transmit left-circularly polarized light or right-circularly polarized light, and
reflect the other one among the left-circularly polarized light or right-circularly polarized light.

3. The display panel (10) as claimed in any one of the preceding claims 1 to 2, wherein the pixel electrode **(221R,** 221G, 221B) further comprises a first oxide conductor (221Bb, 221Gb, 221Rb) between the chiral metasurface reflector (221Ba, 221Ga, 221Ra) and the emission layer (222bR, 222bG, 222bB).

4. The display panel (10) as claimed in claim 3, wherein the pixel electrode (221R, 221G, 221B) further comprises a second oxide conductor (221Bc, 221Gc, 221Rc) between the thickness adjustment layer (213) and the chiral metasurface reflector (221Ba, 221Ga, 221Ra).

5. The display panel (10) as claimed in any one of the preceding claims 1 to 4, further comprising a common electrode (223) over the emission layer (222bR, 222bG, 222bB).

6. The display panel (10) as claimed in claim 5, further comprising:
a λ/4 phase retardation plate (410) on the common electrode (223); and
a linear polarization plate (420) on the λ/4 phase retardation plate (410).

7. The display panel (10) as claimed in any one of the preceding claims 1 to 6, wherein a distance d1 between the chiral metasurface reflector (221Ba, 221Ga, 221Ra) and the emission layer (222bR) is d1=nλ/2, where λ refers to a wavelength of light emitted from the emission layer (222bR, 222bG, 222bB) and n is a natural number.

8. The display panel (10) as claimed in claim 7, wherein the distance d1 between the chiral metasurface reflector (221Ba, 221Ga, 221Ra) and the emission layer (222bR, 222bG, 222bB) is d1=λ/2.

9. The display panel (10) as claimed in any of the preceding claims 1 to 8, whereina distance d2 between the reflective plate (224) and the emission layer (222bR, 222bG, 222bB) is d2=(2k+1)λ/4, where λ refers to a wavelength of light emitted from the emission layer (222bR, 222bG, 222bB) and k is 0 or a natural number.

10. The display panel (10) as claimed in claim 9, wherein the distance d2 between the reflective plate (224) and the emission layer (222bR, 222bG, 222bB) is d2=λ/4.

11. The display panel (10) as claimed in any one of the preceding claims 6 to 10,
a plurality of pixel electrodes (221R, 221G, 221B) on the substrate (100), each pixel electrode (221R, 221G, 221B) comprising the chiral metasurface reflector (221Ba, 221Ga, 221Ra);
a plurality of emission layers (222bR, 222bG, 222bB) on the respective pixel electrode (221R, 221G, 221B) emitting light of at least three different wavelengths λ_{R}, λ_{B}, λ_{G},
wherein, for each area of the display panel (100) corresponding to an emission layer (222bR, 222bG, 222bB), the distance d1 and/or the distance d2 is provided according to the wavelength λ referring to one among the wavelengths λ_{R}, λ_{B}, λ_{G} of red light, blue light or green light emitted from the respective emission layer (222bR, 222bG, 222bB).

12. The display panel (10) as claimed in claim 11, wherein, for each emission layer (222bR, 222bG, 222bB), a thickness of the adjustment layer (213) between the reflective plate (224) and the pixel electrode (221R) is selected so that d2=(2k+1)λ/4.

13. The display panel (10) as claimed in any one of the preceding claims 1 to 12, wherein the chiral metasurface reflector (221Ba, 221Ga, 221Ra) comprises a plurality of nano antennas, wherein each of the nano antennas comprises a body portion (221RaB) and prong portions (221RaP) radially extending from the body portion (221RaB).

14. The display panel (10) as claimed in any of the preceding claims 1 to 13, wherein the chiral metasurface reflector (221Ba, 221Ga, 221Ra) comprises nano antennas each having a rectangular shape in plan view.

15. An electronic apparatus (1) comprising:
a processor (51); and
a display panel (10) according to any of the preceding claims 1 to 14, the processor (51) configured to control the display panel (51).
